# FASCICULE DE BREVET EUROPEEN

(11) **EP 4 016 585 B1**
(45) Date de publication et mention de la délivrance du brevet: **02.08.2023**
(21) Numéro de dépôt: 21212659.3
(22) Date de dépôt: 07.12.2021
(51) Int. Cl.: H01L 21/02, H01L 21/18, H01L 21/04

(54) **DISPOSITIF ÉLECTRONIQUE EN CARBURE DE SILICIUM ET SON PROCÉDÉ DE FABRICATION**
ELEKTRONISCHE VORRICHTUNG AUS SILICIUMCARBID UND IHR HERSTELLUNGSVERFAHREN
SILICON CARBIDE ELECTRONIC DEVICE AND METHOD FOR MANUFACTURING SAME

(30) Priorité: 17.12.2020 FR 2013524
(43) Date de publication de la demande: 22.06.2022
(73) Titulaire: Commissariat à l'Energie Atomique et aux Energies Alternatives, 75015 Paris (FR)
(72) Inventeur: WIDIEZ, Julie, 38054 GRENOBLE CEDEX 09 (FR)
(74) Mandataire: Cabinet Beaumont

(56) Documents cités:
- EP-A1- 2 040 285
- EP-A1- 3 605 585
- WO-A1-2018/131449
- WO-A1-2018/160785
- US-A1- 2017 204 531

## Description

### Domaine technique

La présente description concerne de façon générale les dispositifs électroniques en siliciure de carbone et leur procédé de fabrication.

### Technique antérieure

La présente description porte notamment sur des substrats monocristallins ou des couches monocristallines de siliciure de carbone (SiC) utilisés, par exemple, pour la réalisation de composants électroniques de puissance. Le cristal SiC comporte de nombreux défauts étendus (en anglais extended defects), notamment des dislocations de plan basal (BPD, sigle anglais pour Basal Plane Dislocation), des dislocations de type coin (TED, sigle anglais pour Threading Edge Dislocation), des dislocations de type vis (TSD, sigle anglais pour Threading Screw Dislocation), des microtrous (MP, sigle anglais pour Micropipe), et des fautes d'empilement (SF, sigle anglais pour Stacking Fault). Les défauts ayant l'impact le plus négatif sur les performances électriques des dispositifs électroniques utilisant des substrats monocristallins en SiC sont les TSD, les MP, les BPD et les SF. Aujourd'hui, les fabricants de substrats en SiC monocristallins sont parvenus à réduire la densité de TSD et de MP de sorte que ces défauts n'ont plus d'impact significatif sur les performances électriques des composants électroniques réalisés avec ces substrats. Les défauts BPD sont maintenant pénalisants.

La fabrication d'un substrat monocristallin en SiC ayant une densité de défauts étendus, et notamment une densité de BPD, inférieure à 1000 défauts/cm² présente un coût élevé. Pour réduire les coûts de fabrication d'un dispositif électronique utilisant un tel substrat en SiC, il est connu d'utiliser une couche fine de SiC monocristallin au lieu d'un substrat épais de SiC monocristallin, la couche fine étant maintenue sur un substrat support de coût de fabrication plus faible.

En particulier, il est connu de reporter une fine couche de SiC monocristallin ayant une faible densité de défauts sur un support en SiC monocristallin ayant une densité élevée de défauts, le support en SiC ayant avantageusement le même coefficient de dilatation que la couche fine de SiC. Toutefois, lors des étapes ultérieures du procédé de fabrication du dispositif électronique, qui comprennent généralement des étapes à fort budget thermique (recuit et/ou croissance épitaxiale de SiC depuis la couche fine, ...), on peut observer la propagation de défauts du support dans le reste du dispositif électronique, ce qui n'est pas souhaitable.
Afin d'améliorer la qualité de la couche monocristalline, WO2018131449 A1 divulgue une tranche épitaxiale de carbure de silicium (SiC) qui est pourvue d'un substrat monocristallin de SiC dont la surface principale a un angle de dégagement de 0,4° à 5° par rapport au plan (0001) et une couche épitaxiale qui est située sur le substrat monocristallin de SiC, la couche épitaxiale ayant une densité de dislocations dans le plan basal de 0,1/cm2 ou moins dans une zone située entre le substrat monocristallin de SiC et la surface extérieure, et une densité de défauts triangulaires intérieure 3C de 0,1/cm2 ou moins ;
EP3605585 A1 divulgue une méthode comprenant une étape de reformage de la surface consistant à modifier les propriétés de la surface (0001) de la plaquette de SiC non traitée, de manière à augmenter le taux de propagation des dislocations du plan basal sur la surface de la plaquette de SiC non traitée en tant que dislocations de bord de filetage au moment de la formation de la couche épitaxiale ;
WO2018160785A1 propose l'introduction d'une couche tampon de SiC sur la surface d'un substrat de SiC et l'application d'un mélange fondu directement sur la couche tampon pour former une couche tampon traitée avant la croissance épitaxiale ;
US2017204531A1 propose une méthode de fabrication de semi-conducteurs, comprenant la formation d'une texture périodique dans une direction perpendiculaire à une direction <-1100> d'un substrat SiC, dans laquelle un angle entre un plan basal du substrat SiC et une surface de la texture formée est inférieur à un angle off ; et le dépôt d'un film épitaxial sur le substrat SiC ;
EP2040285 A1 divulgue une méthode de fabrication d'un substrat à orientation mixte comprenant les étapes suivantes : fournir un substrat donneur avec une première orientation cristalline, former une zone de séparation prédéterminée dans le substrat donneur, fournir un substrat de poignée, en particulier d'une deuxième orientation cristalline, fixer le substrat donneur au substrat de poignée et détacher le substrat donneur au niveau de la zone de séparation prédéterminée, transférant ainsi une couche du substrat donneur sur le substrat de poignée pour former un substrat à orientation mixte.

### Résumé de l'invention

Un mode de réalisation pallie tout ou partie des inconvénients des dispositifs électroniques en SiC connus réalisés à partir d'une fine couche de SiC reportée sur un substrat bas coût.

Selon un mode de réalisation, le dispositif électronique a un coût de fabrication réduit.

Un mode de réalisation prévoit un dispositif électronique comprenant un empilement d'un substrat support en SiC monocristallin ayant une première face et d'une couche en SiC monocristallin comprenant une deuxième face en vis-à-vis de la première face. La première face correspond à un plan (11-20) du monocristal de SiC du substrat support et la deuxième face correspond à un plan incliné d'au moins 1 ° par rapport au plan (11-20) du monocristal de SiC de la couche.

Selon un mode de réalisation, le substrat support a une densité de défauts étendus supérieure à 1000 défauts BPD/cm².

Selon un mode de réalisation, la couche a une densité de défauts inférieure à 250 défauts BPD/cm².

Selon un mode de réalisation, la deuxième face est en contact mécanique, également appelé contact physique, avec la première face.

Selon un mode de réalisation, le dispositif comprend au moins un composant électronique formé au moins par traitement de la couche.

Un mode de réalisation prévoit également un procédé de fabrication d'un dispositif électronique comprenant la fourniture d'un substrat support en SiC monocristallin ayant une première face, la formation d'une couche en SiC monocristallin fixé au substrat support, la couche comprenant une deuxième face en vis-à-vis de la première face, la première face correspondant à un plan (11-20) du monocristal de SiC du substrat support et la deuxième face correspondant à un plan incliné d'au moins 1 ° par rapport au plan (11-20) du monocristal de SiC de la couche.

Selon un mode de réalisation, le procédé comprend la formation de ladite couche à partir d'un substrat en SiC monocristallin.

Selon un mode de réalisation, le procédé comprend la croissance épitaxiale de SiC monocristallin sur ledit substrat.

Selon un mode de réalisation, le procédé comprend la formation d'une zone fragilisée dans le substrat selon un plan et la séparation du substrat selon ledit plan en deux parties dont l'une correspond à une couche fixée audit substrat support.

Selon un mode de réalisation, le procédé comprend la croissance épitaxiale de SiC monocristallin sur ladite couche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif électronique ;
la figure 2A illustre une étape d'un mode de réalisation d'un procédé de fabrication du dispositif électronique de la figure 1 ;
la figure 2B illustre une autre étape du procédé ;
la figure 2C illustre une autre étape du procédé ;
la figure 2D illustre une autre étape du procédé ;
la figure 2E illustre une autre étape du procédé ;
la figure 2F illustre une autre étape du procédé ;
la figure 2G illustre une autre étape du procédé ;
la figure 3A illustre une étape d'un autre mode de réalisation d'un procédé de fabrication du dispositif électronique de la figure 1 ;
la figure 3B illustre une autre étape du procédé ;
la figure 3C illustre une autre étape du procédé ;
la figure 3D illustre une autre étape du procédé ;
la figure 4A illustre une étape d'un autre mode de réalisation d'un procédé de fabrication du dispositif électronique de la figure 1 ;
la figure 4B illustre une autre étape du procédé ;
la figure 4C illustre une autre étape du procédé ; et
la figure 4D illustre une autre étape du procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les étapes de fabrication de composants électroniques sur et/ou dans un substrat de SiC sont bien connus de l'homme du métier et ne sont pas décrits en détail.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif électronique dans une position normale d'utilisation. Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

Dans la suite de la description, la densité de défaut d'un monocristal SiC désigne la densité de défauts BPD.

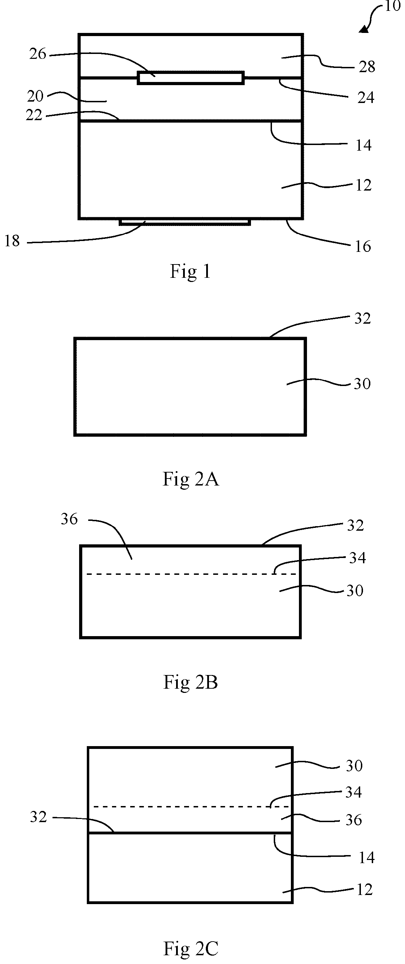

La figure 1 est une vue en coupe, partielle et schématique, d'un dispositif électronique 10.

Le dispositif électronique 10 comprend :
- un substrat support 12 en SiC monocristallin avec une première densité de défauts, ayant une face supérieure 14 et une face inférieure 16, opposée à la face supérieure 14 ;
- éventuellement au moins une piste métallique 18 au contact de la face inférieure 16 du substrat support 12 ;
- une couche 20 en SiC monocristallin avec une deuxième densité de défauts inférieure à la première densité de défauts, la couche 20 ayant une face inférieure 22 reposant sur la face 14 et au contact du substrat support 12, et une face supérieure 24 du côté opposé au substrat support 12 ; et
- une structure 28 d'interconnexion et/ou de revêtement recouvrant la couche 20 du côté de la face 24.

Le dispositif électronique 10 peut éventuellement comprendre au moins un composant électronique, représenté très schématiquement par une zone 26 de forme carrée en figure 1. Le composant électronique 26 peut être formé dans la couche 20 et/ou sur la couche 20. Le composant électronique 26 peut s'étendre sur toute l'épaisseur de la couche 20 et/ou sur toute l'épaisseur du substrat support 12, notamment dans le cas d'un composant électronique de puissance.

Selon une variante, le dispositif électronique 10 peut comprendre un support, non représenté, sur lequel est fixé le substrat support 12, du côté de la face inférieure 16.

Le substrat support 12 est en SiC monocristallin. Selon un mode de réalisation, le substrat support 12 est du polytype 4H, qui présente un système cristallin hexagonal. A titre de variante, le substrat support 12 est du polytype 6H, ou d'un autre polytype. La densité de BPD du substrat support 12 est supérieure à 1000 défauts/cm², de préférence supérieure à 1500 défauts/cm², plus préférentiellement supérieure à 3000 défauts/cm². Selon un mode de réalisation, les faces 14 et 16 sont sensiblement planes. De préférence, les faces 14 et 16 sont parallèles. La face supérieure 14 correspond à un plan basal du cristal, c'est-à-dire à un plan cristallographique (11-20). L'épaisseur du substrat support 12 est comprise entre 300 µm et 1000 µm, avant une éventuelle étape d'amincissement. Après une étape d'amincissement, l'épaisseur du substrat support 12 peut être réduite jusqu'à typiquement 150 µm. Le substrat support 12 peut être dopé.

La couche 20 est en SiC monocristallin. La densité de BPD de la couche 20 est inférieure à 1000 défauts/cm2, de préférence inférieure à 500 défauts/cm², plus préférentiellement inférieure à 250 défauts/cm², encore plus préférentiellement inférieure à 100 défauts/cm². Selon un mode de réalisation, la face 22 est sensiblement plane. Selon un mode de réalisation, la face 24 est sensiblement plane. Selon un mode de réalisation, les faces 22 et 24 sont parallèles. La face supérieure 24 correspond à un plan formant un angle, par rapport au plan (11-20) du cristal, entre 1 ° et 10 °, de préférence entre 2 ° et 8 °, en particulier égal à environ 4 °. L'épaisseur de la couche 20 est comprise entre 100 nm et 15 µm.

La couche 20 peut être dopée. La concentration de dopants dans la couche 20 peut ne pas être homogène. Selon un mode de réalisation, la couche 20 peut comprendre un empilement au moins de première et deuxième sous-couches de SiC monocristallin, reliées entre elles par une relation d'épitaxie, avec des concentrations différentes de dopants.

Selon un mode de réalisation, la couche 20 peut comprendre une densité de BPD homogène. A titre de variante, la couche 20 peut comprendre un empilement au moins de première et deuxième sous-couches de SiC monocristallin, reliées entre elles par une relation d'épitaxie, la première sous-couche étant située du côté du substrat support 12, la densité de BPD de la deuxième sous-couche étant inférieure à la densité de BPD de la première sous-couche. La densité de BPD de la première sous-couche peut être comprise entre 100 défauts/cm² et 500 défauts/cm², et la densité de BPD de la deuxième sous-couche 38 peut être inférieure à 50 défauts/cm².

Le composant électronique 26 peut être destiné à un fonctionnement hyperfréquence, à haute température et/ou à haute tension. A titre d'exemple, il peut correspondre à une diode Schottky, un transistor JFET, un transistor MOSFET, un transistor bipolaire ou un thyristor. Le composant électronique 26 peut être formé en processant la couche 20 et éventuellement le substrat support 12.

La structure 28 peut correspondre à une couche isolante. A titre de variante, elle peut comprendre un empilement de couches isolantes entre lesquels et au travers desquelles s'étendent des pistes conductrices et des vias conducteurs.

Les figures 2A à 2G sont des vues en coupe, partielles et schématiques, de structures obtenues à des étapes successives d'un mode de réalisation d'un procédé de fabrication du dispositif électronique 10 représenté en figure 1.

La figure 2A représente un substrat 30 de SiC monocristallin ayant une face supérieure 32. La densité de BPD du substrat 30 est inférieure à 1000 défauts /cm², de préférence inférieure à 500 défauts/cm², plus préférentiellement inférieure à 250 voire 100 défauts/cm². La face supérieure 32 correspond sensiblement à un plan qui présente un angle de découpe. L'angle de découpe est défini comme l'angle entre la surface moyenne libre du monocristal et un plan cristallographique dense du monocristal. Dans le cas du SiC hexagonal, le plan cristallographique dense est le plan (11-20). La face supérieure 32 présente un angle de découpe par rapport au plan (11-20) compris entre 1 ° et 10 °, de préférence entre 2 ° et 8 °, en particulier égal à environ 4 °.

La figure 2B représente la structure obtenue après une étape d'implantation ionique du côté de la face supérieure 32, qui conduit à la formation d'une zone fragile enterrée 34 sensiblement plane dans le substrat 30, délimitant avec la face supérieure 32 une couche mince 36 qui va être transférée comme cela est décrit plus en détail par la suite. La couche 36 est destinée à faire partie de la couche 20 décrite précédemment, comme cela est décrit plus en détail par la suite. Le procédé de transfert ou de report connu sous l'appellation « Smart Cut^{™} » est largement connu de la littérature. L'étape d'implantation ionique peut être une étape d'implantation d'espèces légères, par exemple d'hydrogène, d'hélium ou une combinaison de ces deux espèces. L'ajustement de l'énergie d'implantation permet de faire varier la profondeur d'implantation, c'est-à-dire la distance entre le plan 34 et la face supérieure 32. Les énergies d'implantation peuvent être comprises entre 40 keV et 200 keV. Les doses utilisées peuvent être comprises entre 10¹⁶/cm² et 10¹⁷/cm². L'implantation ionique peut être réalisée à une température inférieure à 500 °C, notamment à température ambiante. Le plan 34 est sensiblement parallèle à la face 32 et présente donc un angle par rapport au plan (11-20) du cristal SiC compris entre 1 ° et 10 °, de préférence entre 2 ° et 8 °, en particulier égal à environ 4 °. Alternativement, la couche 20 peut être formée à partir d'autres techniques de transfert de couches minces connues.

La figure 2C représente la structure obtenue après une étape d'assemblage du substrat 30 sur le substrat support 12, et plus précisément de la face 32 du substrat 30 sur la face 14 du substrat support 12. Selon un mode de réalisation, le collage du substrat 30 au substrat support 12 est un collage direct, c'est-à-dire sans apport d'un matériau de collage entre le substrat 30 et le substrat support 12. Il peut comprendre la formation d'une couche sur la face 32 du substrat 30 et/ou sur la face 14 du substrat support 12 pour faciliter l'assemblage du substrat 30 avec le substrat support 12, cette couche pouvant être une couche métallique, par exemple en tungstène (W), une couche semiconductrice, par exemple en silicium (Si) ou en SiC amorphe. L'étape de collage par collage direct consiste à mettre en contact la face 32 du substrat 30 contre la face 14 du substrat support 12, ce qui entraîne le collage moléculaire du substrat 30 sur le substrat support 12. Ce collage peut être réalisé en atmosphère ambiante, ou sous une atmosphère contrôlée et en particulier sous un vide poussé, de l'ordre de 10⁻⁶ Pa ou moins. Il peut être réalisé à température ambiante ou à plus haute température, assisté ou non d'une compression. Un recuit thermique est généralement réalisé pour consolider le collage.

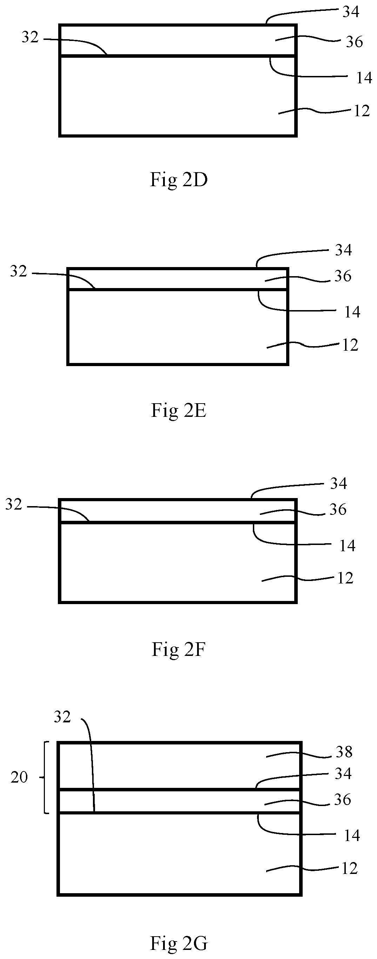

La figure 2D représente la structure après une étape de séparation du substrat 30 au niveau du plan fragile enterré 34 en deux parties, la couche 36 restant fixée au substrat support 12. Selon un mode de réalisation, l'épaisseur de la couche 36 est par exemple comprise entre 100 nm et 1,5 µm. L'étape de séparation peut comprendre un apport suffisant d'énergie pour séparer le substrat 30 en deux parties au niveau du plan 34. L'apport d'énergie peut comprendre un apport d'énergie thermique, par exemple par un recuit ou un balayage laser, ou un apport d'énergie mécanique ou encore une combinaison de sollicitations thermiques et mécaniques.

La structure obtenue comprend donc une couche 36 de SiC monocristallin comportant une faible densité de BPD (inférieure à 1000 défauts/cm², de préférence inférieure à 500 défauts/cm², plus préférentiellement inférieure à 100 défauts/cm²), sur un substrat support 12 à bas coût comportant une plus forte densité de BPD (supérieure à 1000 défauts/cm² et de préférence supérieure à 1500 voire 3000 défauts/cm²) . De façon avantageuse, au cours des traitements thermiques (pendant le recuit de renforcement de collage et/ou l'étape de séparation du substrat 30), les BPD du substrat support 12 ont été bloqués dans le plan basal de la face 14 et n'ont pas émergé dans la couche 36, qui reste donc de très bonne qualité.

La face exposée de la couche 36 qui correspond sensiblement au plan 34, présente un angle de découpe par rapport au plan (11-20) du cristal SiC compris entre 1 ° et 10 °, de préférence entre 2 ° et 8 °, en particulier égal à environ 4 °.

La figure 2E représente la structure obtenue après des étapes de nettoyage, de polissage, de lissage ou de gravure de la face 34 de la couche 36. Ceci peut entraîner un amincissement de la couche 36, la face libre 34 obtenue après cette étape de polissage présentant toujours un angle de découpe par rapport au plan (11-20) du cristal SiC compris entre 1 ° et 10 °, de préférence entre 2 ° et 8 °, en particulier égal à environ 4 °.

La figure 2F représente la structure obtenue après une étape de recuit thermique, par exemple à une température supérieure à 1500 °C, par exemple à environ 1700 °C, pendant une durée supérieure à 10 minutes, par exemple pendant environ 30 minutes. De façon avantageuse, au cours du recuit, les BPD du substrat support 12 sont bloqués dans le plan basal de la face 14 et n'émergent pas dans la couche 36. Les étapes décrites précédemment en relation avec les figures 2E et 2F permettent d'éliminer sensiblement tous les défauts induits lors de l'implantation ionique.

La figure 2G représente la structure obtenue après une étape de croissance d'une couche 38 de SiC monocristallin par épitaxie sur la couche 36 depuis la face 34. La couche 38 peut avoir un dopage différent de la couche 36. Elle peut avoir une densité de défauts inférieure à la densité de défauts de la couche 36. Cette étape permet de réaliser la couche 38 avec une densité de BPD plus faible, de l'ordre de 10 fois à 100 fois plus faible que la densité de BPD de la couche 36. Ceci est dû au fait que les BPD sont transformée en TED pendant l'étape d'épitaxie en contrôlant de façon adéquate les paramètres de croissance lors de l'étape d'épitaxie, notamment la vitesse de croissance ou encore le ratio C/S. Les TED sont des défauts qui n'impactent pas ou peu les dispositifs électriques contrairement au BPD. La couche 38 de SiC épitaxiée peut comprendre une densité de BPD inférieure à 50 défauts/cm². L'ensemble des couches 36 et 38 forme alors la couche de SiC 20 décrite précédemment en relation avec la figure 1. Cette couche 20 a avantageusement une épaisseur supérieure à 3 µm, typiquement de l'ordre de 5 à 15 µm, voire plus pour permettre notamment la réalisation de composants de puissance. La face supérieure 34 de la couche 36 présentant un angle par rapport au plan (11-20) du cristal de SiC entre 1 ° et 10 °, de préférence entre 2 ° et 8 °, en particulier égal à environ 4 °, la croissance par épitaxie de la couche 38 peut être réalisée par des procédés compatibles avec une exploitation industrielle. En effet, la croissance épitaxiale sur une face libre du cristal de SiC présentant un angle par rapport au plan (11-20) du cristal de SiC inférieure à 1 ° peut difficilement être réalisée par des procédés compatibles avec une exploitation industrielle. De façon avantageuse, pendant l'épitaxie réalisée à haute température, les BPD du substrat support 12 sont bloqués dans le plan basal de la face 14 et n'émergent pas dans la couche 20, qui reste donc de très bonne qualité.

A titre de variante, la couche 38 n'est pas présente. La couche 36 correspond alors à la couche 20 décrite précédemment en relation avec la figure 1. Elle peut être directement processée pour réaliser des composants.

Le procédé peut comprendre des étapes ultérieures de formation de composants électroniques, notamment au niveau de la couche 20 et matérialisé sur la figure 1 par la zone 26 et de formation de la structure d'interconnexion/de revêtement 28 décrits précédemment en relation avec la figure 1. De façon avantageuse, au cours de ces étapes ultérieures, les BPD du substrat support 12 sont également bloqués dans le plan (11-20) de la face 14 et n'émergent pas à travers la couche 20.

Ces étapes ultérieures peuvent en outre comprendre l'amincissement du substrat support 12, par exemple par polissage, meulage, et/ou gravure chimique. Ces étapes ultérieures peuvent comprendre la formation des pistes métalliques 18. A titre d'exemple, plusieurs exemplaires du dispositif électronique 10 peuvent être réalisées dans et sur la couche 20. Il peut alors être prévu une étape de séparation des dispositifs électroniques, par exemple par sciage.

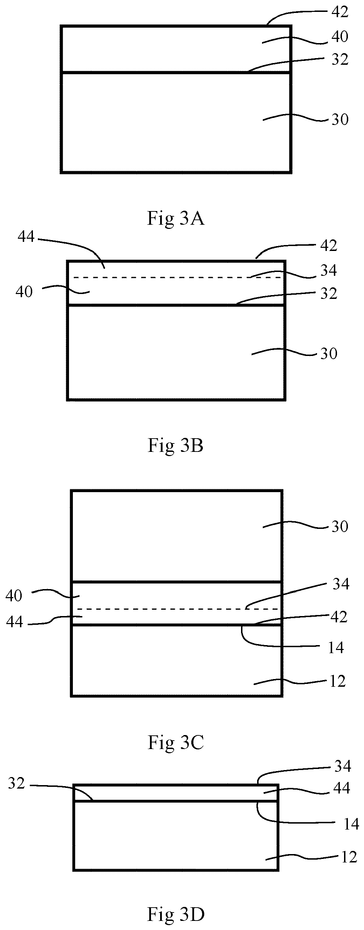

Les figures 3A à 3D sont des vues en coupe, partielles et schématiques, de structures obtenues à des étapes successives d'un autre mode de réalisation d'un procédé de fabrication du dispositif électronique 10 représenté en figure 1.

La figure 3A représente la structure obtenue après une étape de croissance d'une couche 40 de SiC par épitaxie sur le substrat 30 de SiC depuis la face 32. Comme cela a été décrit précédemment, le substrat 30 présente une bonne qualité cristalline avec peu de défauts, la densité de BPD du substrat 30 étant inférieure à 1000 défauts /cm², de préférence inférieure à 500 défauts/cm², plus préférentiellement inférieure à 250 voire 100 défauts/cm². La couche 40 peut avoir le même dopage ou un dopage différent du substrat 30 de SiC. Cette étape permet de réaliser la couche 40 avec une densité de BPD plus faible de préférence 10 fois plus faible, plus préférentiellement 100 fois plus faible, que la densité de BPD du substrat 30. Ceci est dû au fait que les BPD sont transformée en TED pendant l'étape d'épitaxie en contrôlant de façon adéquate les paramètres de croissance lors de l'étape d'épitaxie, notamment la vitesse de croissance ou encore le ratio C/S. Les TED sont des défauts qui n'impactent pas ou peu les dispositifs électriques contrairement au BPD. La couche 40 présente une face libre 42.

La figure 3B représente la structure obtenue après une étape d'implantation qui conduit à la formation d'un plan fragile enterré 34 dans la couche 40, délimitant, avec la face libre 42 de la couche 40, une couche mince 44 destinée à être transférée comme cela est décrit en détail par la suite. L'étape d'implantation peut être mise en oeuvre comme cela a été décrit précédemment en relation avec la figure 2B.

La figure 3C représente la structure obtenue après une étape de collage de la couche 40 sur le substrat support 12, et plus précisément de la face 42 de la couche 40 sur la face 14 du substrat support 12. L'étape de collage peut être mise en oeuvre comme cela a été décrit précédemment en relation avec la figure 2C.

La figure 3D représente la structure obtenue après une étape de séparation de la couche 40 au niveau du plan fragile enterré 34 en deux parties, la couche 44 restant fixée au substrat support 12. L'étape de séparation peut être mise en oeuvre comme cela a été décrit précédemment en relation avec la figure 2D.

La structure obtenue comprend donc une couche 44 de SiC monocristallin comportant une faible densité de BPD (inférieure à 500 défauts/cm², de préférence inférieure à 250 défauts/cm², plus préférentiellement inférieure à 100 défauts/cm²) sur un substrat support 12 à bas coût comportant une plus forte densité de BPD. La face exposée de la couche 44 qui correspond sensiblement au plan 34, présente un angle de découpe par rapport au plan basal du SiC entre 1 ° et 10 °, de préférence entre 2 ° et 8 °, en particulier environ 4 °.

Les étapes ultérieures du procédé peuvent correspondre à ce qui a été décrit précédemment en relation avec les figures 2E à 2G.

Si une couche est épitaxiée sur la couche 44 transférée, la densité de BPD dans cette couche sera davantage réduite, d'un facteur de l'ordre de 10 à 100 par rapport à la couche 44. On obtient ainsi une densité de BPD inférieure à 50 défauts/cm², de préférence inférieure à 20 défauts/cm², plus préférentiellement inférieure à 10 défauts/cm².

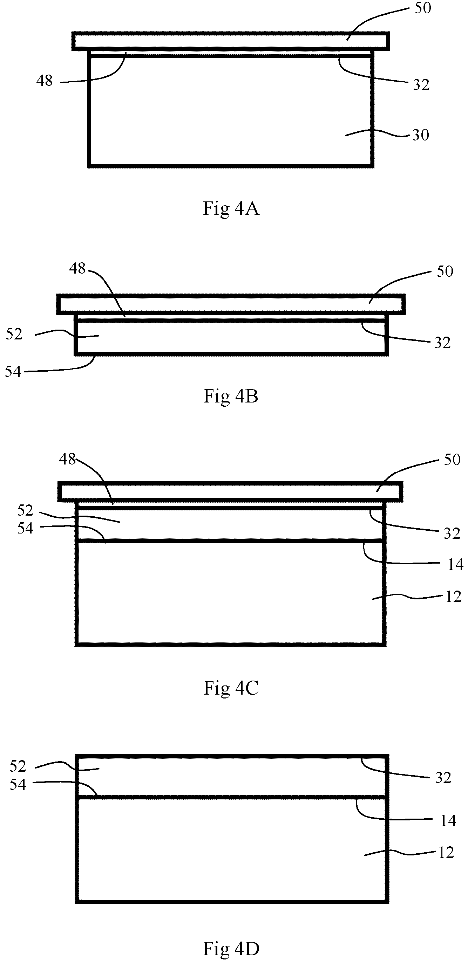

Les figures 4A à 4D sont des vues en coupe, partielles et schématiques, de structures obtenues à des étapes successives d'un autre mode de réalisation d'un procédé de fabrication du dispositif électronique 10 représenté en figure 1 pour lequel le prélèvement du film monocristallin est réalisé par une technique de pelage (spalling en anglais) .

La figure 4A représente la structure obtenue après une étape de dépôt d'une couche 48 fortement contrainte, par exemple de nitrure sur la face supérieure 32 du substrat 30 et une étape d'application d'une bande adhésive 50 à la surface de la couche contrainte 48.

La figure 4B représente la structure obtenue après une étape de séparation par pelage d'une couche 52 du substrat 30 solidaire de la couche contrainte 48 qui reste fixée à la bande adhésive 50. La couche 52 présente une face libre 54 du côté opposé à la bande adhésive 50. L'épaisseur de la couche 52 peut être comprise entre 100 nm et 1,5 µm.

La figure 4C représente la structure obtenue après une étape d'adhésion de la couche 52 sur le substrat support 12, et plus précisément de la face 54 de la couche 52 sur la face 14 du substrat support 12. L'étape de collage peut être mise en oeuvre comme cela a été décrit précédemment en relation avec la figure 2C après un traitement de surface adaptée de la face 54, et notamment un polissage mécano-chimique, pour la rendre compatible avec ce collage. En effet, la face 54 est très rugueuse après le pelage.

La figure 4D représente la structure obtenue après le retrait de la bande adhésive 50 puis le retrait de la couche contrainte 48, par exemple par une gravure sélective.

Les étapes ultérieures du procédé peuvent correspondre à ce qui a été décrit précédemment en relation avec les figures 2E à 2G.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le mode de réalisation décrit en relation avec les figures 3A à 3D peut être mis en oeuvre avec le mode de réalisation décrit en relation avec les figures 4A à 4D.

Enfin, la mise en oeuvre pratique des modes de réalisation et variantes décrits est à la portée de la personne du métier à partir des indications fonctionnelles données ci-dessus.

## Revendications

1. Dispositif électronique comprenant un empilement d'un substrat support (12) en SiC monocristallin ayant une première face (14) et d'une couche (20) en SiC monocristallin comprenant une deuxième face (22) en vis-à-vis de la première face, dans lequel la première face correspond à un plan (11-20) du monocristal de SiC du substrat support et la deuxième face correspond à un plan incliné d'au moins 1 ° par rapport au plan (11-20) du monocristal de SiC de la couche (20).

2. Dispositif électronique selon la revendication 1, dans lequel le substrat support (12) a une densité de défauts étendus supérieure à 1000 défauts BPD/cm².

3. Dispositif électronique selon la revendication 1 ou 2, dans lequel la couche (20) a une densité de défauts inférieure à 250 défauts BPD/cm².

4. Dispositif électronique selon l'une quelconque des revendications 1 à 3, dans lequel la deuxième face (22) est en contact mécanique avec la première face (14).

5. Dispositif électronique selon l'une quelconque des revendications 1 à 4, comprenant au moins un composant électronique (26) formé au moins par traitement de la couche (20).

6. Procédé de fabrication d'un dispositif électronique comprenant la fourniture d'un substrat support (12) en SiC monocristallin ayant une première face (14), la formation d'une couche (20 ; 36 ; 44) en SiC monocristallin fixé au substrat support, la couche comprenant une deuxième face (22) en vis-à-vis de la première face, dans lequel la première face correspond à un plan (11-20) du monocristal de SiC du substrat support et la deuxième face correspond à un plan incliné d'au moins 1 ° par rapport au plan (11-20) du monocristal de SiC de la couche (20).

7. Procédé selon la revendication 6, comprenant la formation de ladite couche (20 ; 36 ; 44) à partir d'un substrat (30) en SiC monocristallin.

8. Procédé selon la revendication 7, comprenant la croissance épitaxiale de SiC monocristallin (40) sur ledit substrat (30) .

9. Procédé selon la revendication 7 ou 8, comprenant la formation d'une zone fragilisée dans le substrat (30) selon un plan (34) et la séparation du substrat (30) selon ledit plan en deux parties dont l'une correspond à une couche (36) fixée audit substrat support (12).

10. Procédé selon l'une quelconque des revendications 6 à 9, comprenant la croissance épitaxiale de SiC monocristallin (38) sur ladite couche (36).

## Patentansprüche

1. Elektronische Vorrichtung aufweisend einen Stapel aus einem Trägersubstrat (12) aus einkristallinem SiC mit einer ersten Oberfläche (14) und einer Schicht (20) aus einkristallinem SiC mit einer zweiten Oberfläche (22), die der ersten Oberfläche gegenüberliegt, wobei die erste Oberfläche einer (11-20) Ebene des SiC-Einkristalls des Trägersubstrats entspricht und die zweite Oberfläche einer Ebene entspricht, die um mindestens 1° in Bezug auf die (11-20) Ebene des SiC-Einkristalls der Schicht (20) geneigt ist.

2. Elektronische Vorrichtung nach Anspruch 1, wobei das Trägersubstrat (12) eine Dichte an ausgedehnten Defekten von mehr als 1.000 BPD-Defekten/cm² aufweist.

3. Elektronisches Bauelement nach Anspruch 1 oder 2, wobei die Schicht (20) eine Defektdichte von weniger als 250 BPD-Defekten/cm2 aufweist.

4. Elektronisches Bauelement nach einem der Ansprüche 1 bis 3, wobei die zweite Oberfläche (22) in mechanischem Kontakt mit der ersten Oberfläche (14) steht.

5. Elektronisches Bauelement nach einem der Ansprüche 1 bis 4, das mindestens ein elektronisches Bauelement (26) aufweist, das zumindest durch Behandlung der Schicht (20) gebildet ist.

6. Verfahren zur Herstellung einer elektronischen Vorrichtung, aufweisend das Bereitstellen eines Trägersubstrats (12) aus einkristallinem SiC mit einer ersten Oberfläche (14), das Ausbilden einer Schicht (20; 36; 44) aus einkristallinem SiC, die an dem Trägersubstrat befestigt ist, wobei die Schicht eine zweite Oberfläche (22) gegenüber der ersten Oberfläche aufweist, wobei die erste Oberfläche einer (11-20) Ebene des SiC-Einkristalls des Trägersubstrats entspricht und die zweite Oberfläche einer Ebene entspricht, die um mindestens 1° in Bezug auf die Ebene (11-20) des SiC-Einkristalls der Schicht (20) geneigt ist.

7. Verfahren nach Anspruch 6, aufweisend das Ausbilden der Schicht (20; 36, 44) aus einem Substrat (30) aus einkristallinem SiC.

8. Verfahren nach Anspruch 7, aufweisend das epitaktische Aufwachsen von einkristallinem SiC (40) auf dem Substrat (30).

9. Verfahren nach Anspruch 7 oder 8, aufweisend das Ausbilden eines geschwächten Bereichs in dem Substrat (30) entlang einer Ebene (34) und das Trennen des Substrats (30) entlang dieser Ebene in zwei Teile, von denen einer einer Schicht (36) entspricht, die mit dem Trägersubstrat (12) verbunden ist.

10. Verfahren nach einem der Ansprüche 6 bis 9, aufweisend das epitaktische Aufwachsen von einkristallinem SiC (38) auf der Schicht (36).

## Claims

1. Electronic device comprising a stack of a support substrate (12) made of single-crystal SiC having a first surface (14) and of a layer (20) made of single-crystal SiC comprising a second surface (22) opposite the first surface, wherein the first surface corresponds to a (11-20) plane of the SiC single crystal of the support substrate and the second surface corresponds to a plane inclined by at least 1° with respect to the (11-20) plane of the SiC single crystal of the layer (20).

2. Electronic device according to claim 1, wherein the support substrate (12) has a density of extended defects greater than 1,000 BPD defects/cm².

3. Electronic device according to claim 1 or 2, wherein the layer (20) has a density of defects smaller than 250 BPD defects/cm².

4. Electronic device according to any of claims 1 to 3, wherein the second surface (22) is in mechanical contact with the first surface (14).

5. Electronic device according to any of claims 1 to 4, comprising at least one electronic component (26) formed at least by treatment of the layer (20).

6. Method of manufacturing an electronic device comprising the provision of a support substrate (12) made of single-crystal SiC having a first surface (14), the forming of a layer (20; 36; 44) made of single-crystal SiC attached to the support substrate, the layer comprising a second surface (22) opposite the first surface, wherein the first surface corresponds to a plane (11-20) of the SiC single crystal of the support substrate and the second surface corresponds to a plane inclined by at least 1° with respect to the plane (11-20) of the SiC single crystal of the layer (20).

7. Method according to claim 6, comprising the forming of said layer (20; 36, 44) from a substrate (30) made of single-crystal SiC.

8. Method according to claim 7, comprising the epitaxial growth of single-crystal SiC (40) on said substrate (30) .

9. Method according to claim 7 or 8, comprising the forming of a fragilized area in the substrate (30) along a plane (34) and the separation of the substrate (30) along said plane into two portions, one of which corresponds to a layer (36) attached to said support substrate (12).

10. Method according to any of claims 6 to 9, comprising the epitaxial growth of single-crystal SiC (38) on said layer (36).
